# EUROPEAN PATENT SPECIFICATION

(11) **EP 2 109 111 B1**
(45) Date of publication and mention of the grant of the patent: **21.12.2011**
(21) Application number: 09157306.3
(22) Date of filing: 03.04.2009
(51) Int. Cl.: G11C 11/16

(54) **System and method for writing data to magnetoresistive random access memory cells**
System und Verfahren zum Schreiben von Daten auf magnetoresistive Direktzugriffsspeicherzellen
Système et procédé pour écrire des données sur des cellules à mémoire à accès aléatoire

(30) Priority: 07.04.2008 US 43038 P
(43) Date of publication of application: 14.10.2009
(73) Proprietor: Crocus Technology S.A., 38025 Grenoble Cedex (FR)
(72) Inventor: Berger, Neal, Cupertino, CA 95014 (US); Javerliac, Virgile, 38100 Grenoble (FR)
(74) Representative: P&TS SA (AG, Ltd.)

(56) References cited:
- WO-A2-2008/010957
- US-A1- 2004 095 801

## Description

### Referebce data

The subject matter of the present application relates to a United States non provisional patent application, Serial No. 11/869,632, filed on October 9, 2007.

### Field of the invention

The present disclosure relates generally to random access memory and more particularly, but not exclusively, to magnetic tunnel junction-based memory cells.

### Description of related art

Magnetic memories MRAM have been the object of a renewed interest with the discovery of magnetic tunnel junctions (MTJ) having a strong magnetoresistance at ambient temperature. These magnetic random access memories present many advantages such as speed (a few nanoseconds of duration of writing and reading), non volatility, and insensitivity to ionizing radiations. Consequently, they are increasingly replacing memory that uses more conventional technology based on the charge state of a capacitor (DRAM, SRAM, FLASH).

Thermally-assisted switching magnetic tunnel junction (TAS-MTJ) based MRAM cells have been described in patent US6950335 and patent application US2006291276. These typical implementations use two dedicated lines for the magnetic field generation and for heating the cell junction or reading the cell state, respectively.

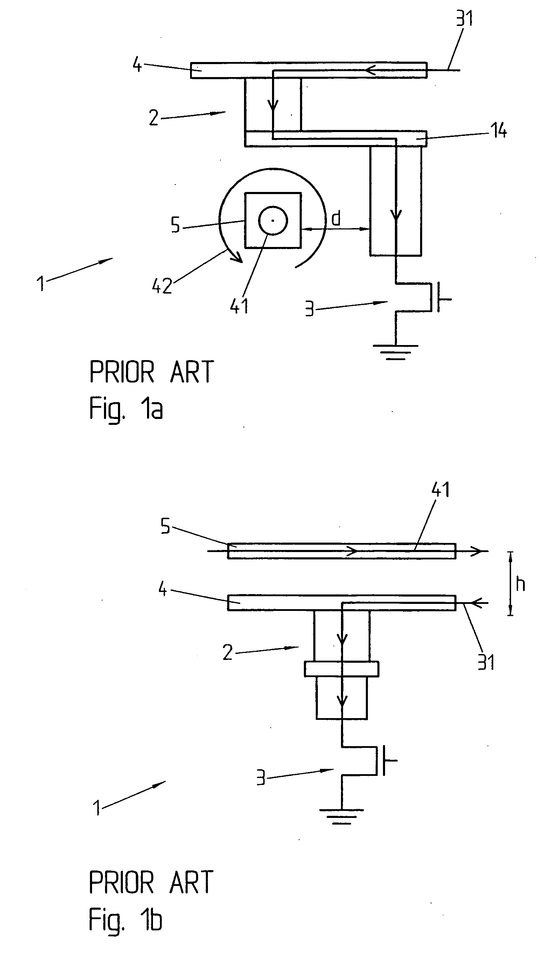

Fig. 1a shows a single memory cell 1 of such a conventional TAS-MTJ based MRAM cell 1 in a first implementation, where the cell 1 comprises a junction 2 placed between a selection CMOS transistor 3 and a bit line 4, represented parallel to the page. Also orthogonal with the bit line 4, a field (or writing) line 5 is placed underneath the junction 2. This configuration requires a strap 7 between the bottom of the junction 2 and the selection transistor 3. More particularly, the field line 5 uses an M2 CMOS metal level and two M1 metal lines are required to contact select transistor source/drain (S/D) nodes. The bit line 4 is at an M3 CMOS level. The cell configuration of Fig. 1a requires, at the M2 level, a minimum spacing d between the field line 5 and the cell strap 7, increasing the size of the cell 1. Using the bottom part of the junction 2 as a strap 7 can increase further the distance between two adjacent cells 1, due to the minimum spacing required between the two corresponding adjacent straps 7.

The writing procedure of the TAS-MTJ based MRAM cell 1 is performed by heating the junction 2 with a heating current 31 passing through the junction 2 via the bit line 4. This is achieved when the transistor 3 is in a conducting mode (ON). Simultaneously or after a short time delay, once the junction 2 has reached a suitable temperature threshold, a field current 41 is passed through the field line 5, producing a magnetic field 42 capable of addressing the junction 2 by switching the magnetization of a soft magnetic layer, or storage layer (not shown), into the appropriate direction. The heating current 31 is then turned off by setting the selection transistor 3 in a cutoff mode (OFF) or by removing the transistor's source drain bias. The field current 41 is maintained during the cooling of the junction 2, and then switched off, once the junction 2 has reached a temperature where the magnetization of the storage layer is frozen in the written state.

Fig. 1b shows a conventional TAS-MTJ based MRAM cell 1 according to an alternative configuration, in which the field line 5 is placed above the magnetic cell 1. In the configuration of Fig. 1b, the field line 5 uses an M3 CMOS metal level. The bit line 4 is disposed at an M2 CMOS level, with the junction 2 being placed between the M1 and M2 levels. This configuration allows for an increased density, or a reduced cell size, since the strap 7 of configuration of Fig. 1 a is no more required and the cell 1 can be stacked on the transistor 3. The writing procedure of the cell 1 of Fig. 1b is similar to the one of the cell 1 of Fig. 1a. However, the larger distance h between the M3 level and the junction 2 requires the use of a field current 41 to write the cell 1 of configuration of Fig. 1b that is typically at least twice as large as the one used to write the cell 1 of configuration of Fig. 1a. Both cell configurations of Fig. 1a and Fig. 1 b require at least three CMOS metal levels.

Patent application US2004095801 discloses a magnetic tunnel junction formed from a nonmagnetic metallic spacer inserted between a thick stable magnet and a thin free magnet with perpendicular anisotropy. During a writing step, the junction is heated by passing a current in order to reduce the anisotropy such as to allow switching the free magnet magnetization using a magnetic field or a spin transfer current.

There is a need for a TAS-MTJ based MRAM cell having lower power consumption and for memory devices comprising an array of TAS-MTJ based MRAM cells having a higher cell density and lower cost of fabrication.

### Brief summary of the invention

An object of the invention is therefore to propose a magnetic random access memory (MRAM) cell which overcomes at least some limitations of the prior art.

According to the invention, these objectives are achieved by means of a method comprising the features of the independent claims, preferred embodiments being indicated in the dependent claims and in the description.

These aims are achieved by means of a method of writing data in the magnetic memory cell with a thermally assisted switching writing procedure, comprising: a magnetic tunnel junction containing at least a first magnetic layer, a second magnetic layer, and an insulating layer being disposed between the first and a second magnetic layers; a select transistor, controlled by a word line; and a current line electrically connected to the junction and having a first function for passing a heating current for heating the junction, and a second function for passing a field current for generating a magnetic field adapted to switch the magnetization of the first magnetic layer when the junction has reached a suitable temperature; the method comprising:
a) turning on the heating current through the junction via the current line in order to heat the junction;
b) turning on the field current through the current line in order to switch the magnetization of the storage layer;
c) after the junction has reached the suitable high temperature threshold, turning off the heating current in order to cool the junction;
d) after the junction has cooled down to a low temperature threshold, turning off the field current; wherein
turning on the heating current is performed prior to turning on the field current, and turning off the heating current is performed after turning on the field current and prior to turning off the field current.

In contrast with the cell configuration of prior art, the cell of the invention requires only two CMOS metal levels resulting in a lower manufacturing complexity and cost. Moreover, the current line being disposed close to the junction, a larger ratio of magnetic field to field current is obtained yielding a cell with low power consumption.

### Brief Description of the Drawings

The invention will be better understood with the aid of the description of an embodiment given by way of example and illustrated by the figures, in which:
Fig. 1 a shows a thermally-assisted switching magnetic tunnel junction, magnetic random access memory (TAS-MTJ MRAM) cell of the prior art in a first configuration;
Fig. 1a shows a TAS-MTJ MRAM cell of the prior art in a second configuration
Fig. 2 illustrates a single-line, TAS-MTJ MRAM cell according to an embodiment of the invention; and
Figs. 3A to D represent pulse sequences for field and heating current passing in the single-line, TAS-MTJ MRAM cell, according to different embodiments of the invention.

It should be noted that the figures are not drawn to scale and that elements of similar structures or functions are generally represented by like reference numerals for illustrative purposes throughout the figures. It also should be noted that the figures are only intended to facilitate the description of the preferred embodiments. The figures do not illustrate every aspect of the present disclosure and do not limit the scope of the disclosure.

### Detailed Description of possible embodiments of the Invention

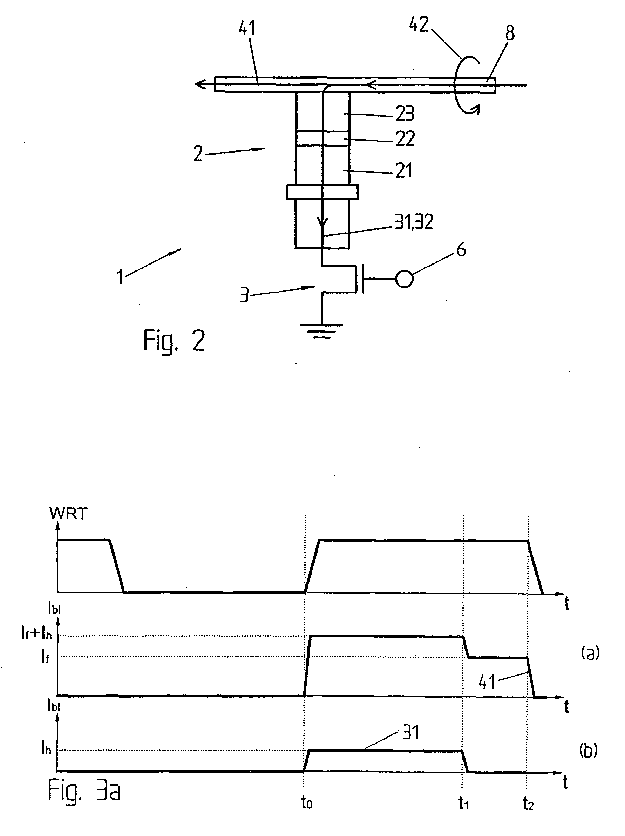

A single-line (SL), thermally-assisted switching (TAS) magnetic tunnel junction (MTJ) based magnetic random access memory (MRAM) cell, called SL-TAS cell 1 in the text below, is represented in Fig. 2 according to an embodiment of the invention. The SL-TAS cell 1 comprises magnetic tunnel junction 2 containing, at least, a first magnetic layer, here a magnetic storage layer 23, a second magnetic layer, here a reference magnetic layer 21, and an insulating layer 22, the insulating layer 22 being inserted between the sense layer 21 and the storage layer 23. The junction 2 is placed between a select transistor 3, for example a CMOS transistor, on the side of the reference layer 21, and a current line 8 electrically connected to the junction 2, on the side of the storage layer 23. A control current line, or word line 6, is used to control the opening and the closing of the transistor 3 in order to address the memory cell 1 individually.

The current line 4, represented parallel to the page in Fig. 2, fulfils both a first function of a bit line, for passing a heating current 31, and a second function of a field line, for passing a field current 41 to produce a magnetic field 42 able of switching the magnetization of the storage layer 23 in the junction 2.

A magnetic memory device (not represented) can be formed by assembling an array comprising a plurality of memory cells 1 of the invention, where each junction 2 of each memory cell 1 is connected on the side of the storage layer 23 to the current line 8 and on the opposite side to the word line 6, placed perpendicular with the current line 8.

In an embodiment of the invention, the writing process of the SL-TAS cell 1 is performed by heating the junction 2 with a first portion of current, here a heating current 31, passing through the junction 2. This is achieved when the transistor 3 is in the conducting mode (ON). Once the junction 2 has reached a suitable temperature, a second portion of the current, here a field current 41, is passed through the current line 8, producing a magnetic field 42 capable of addressing the junction 2 by switching the magnetization of the storage layer 23 into the appropriate direction. The heating current 31 is then turned off by setting the selection transistor 3 in the cutoff mode (OFF) or by removing the transistor's source drain bias. The field current 41 is maintained during the cooling of the junction 2, and then switched off, once the junction 2 has reached a temperature where the magnetization is frozen in the written state.

In another embodiment of the invention not represented, the writing process of the SL-TAS cell 1 is performed by switching the magnetization of the storage layer 23 using a spin polarized write current flowing through the current line 8 and the junction 2 when one of the selection transistors 3 in ON. Such a current induced magnetic switching-based writing operations combined with the TAS-assisted write procedure is described in the case of a MRAM-based memory in patent US6950335. In the present invention, a bias field can be generated by a passing a portion of the spin polarized write current through the current line 8 in order to minimize the magnitude of the spin polarized write current required for the magnetic switching of the storage layer 23.

During the reading procedure, the transistor 3 is switched ON and a sense current 32 is passed through the junction 2 via the current line 8, in order to measure a voltage across the junction 2. The voltage measurement yields the corresponding resistance R of the junction 2. In the case the magnetization orientation of the storage layer 23 imposed by the magnetic field 42 is parallel to the magnetization direction of the reference layer 21, the measured first junction resistance R is low. In contrast, if the first magnetization direction of the storage layer 23 is antiparallel to the magnetization direction of the reference layer 21, a high junction resistance R is measured.

Alternatively, the junction resistance R can be determined by applying a voltage bias through the junction 2 and measuring the corresponding current.

Possible heating current 31 and field current pulse sequences according to the invention are represented in Figs. 3A to 3D where the total current I_{bl} passing in the current line 8 is plotted against time t. More particularly, Graph (b) shows the heating current 31 pulse sequence, graph (a) shows the sum of the heating current 31 and field current 41 pulse sequences, and the upper graph represents the corresponding write time (WRT) sequence.

In an embodiment of the invention represented in Fig. 3A, the heating current 31 is passed through the junction 2 via the current line 8, simultaneously with the field current 41. Here, the field current 41, having a magnitude of I_{f}, and the heating current 31, having a magnitude of Iₕ, are applied in the current line 8 at a time to. The heating current 31 is turned off at a time t₁, once the junction 2 has reached a suitable high temperature threshold. The field current 41 is maintained during the cooling of the junction 2 and then switched off at a time t₂. Here, the time interval t₂ - t₁, must be long enough in order to reach a low temperature threshold at which the magnetization of the storage layer is frozen in the state written by the field current 41. In the upper graph (a) of Fig. 3A, the superimposition of the heating current 31 over the field current 41, yielding a current magnitude of I_{bl} = I_{f} + Iₕ, is visible in the time interval between to and t₁.

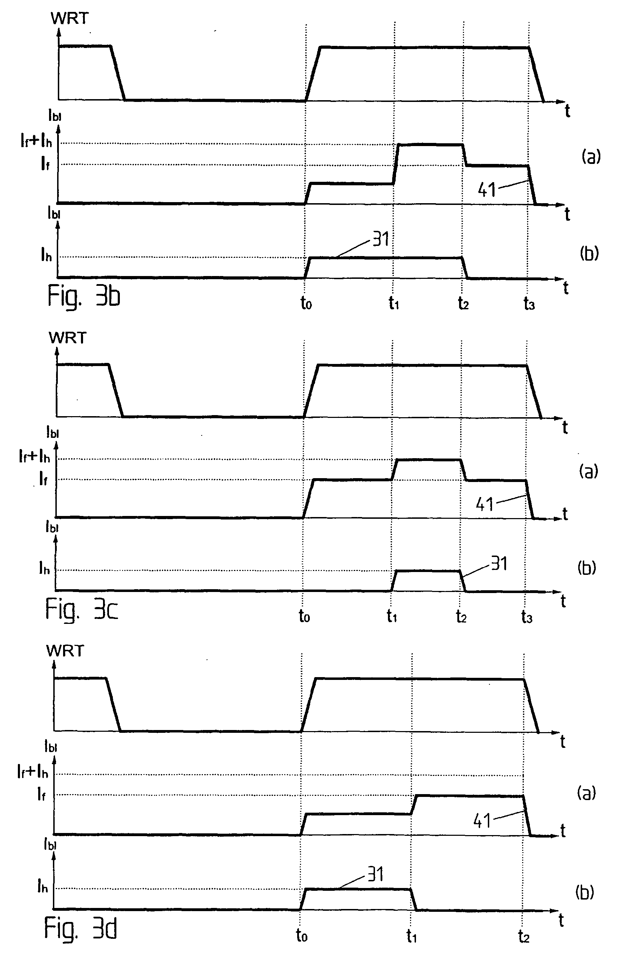

In a preferred embodiment of the invention represented in Fig. 3B, the heating current 31 is first applied in the current line 8 at to and the field current 41 is then applied in the same line 8 at a time t₁, after junction 2 has sufficiently heated in order to allow the magnetization of the storage layer 23 to be easily switched by the magnetic field generated by the field current 41. Again, the field current is maintained until a time t₃ where it is switched off, once the junction 2 has reached a temperature where the magnetization is frozen in the written state. Here, the heating current 31 is maintained until a time t₂, prior to the time t₃ but after the time t₁.

The field and heating currents 41, 31 pulse sequences of Fig. 3A are easier to implement than the pulse sequences of Fig. 3B since the synchronisation of the field and heating currents pulses is simpler. However, the pulse sequences of Fig. 3B yields lower average power consumption due to the shorter duration of the field current 41 pulse.

In another embodiment of the invention represented in Fig. 3C, the field current 41 is first applied in the current line 8 at to and the heating current 31 is then applied in the same line 8 at a time t₁. The heating current is turned off at a time t₂ and the field current 41 is turned off at a time t₃, once the junction 2 has reached a temperature where the magnetization is frozen in the written state. Here, the magnetization of the storage layer 23 is switched during the period of time between t₁ and t₂ when the junction 2 is heated. The pulse sequence of Fig. 3C is likely to exhibit higher average power consumption than the previous pulse sequences of Fig. 3A and 3B due to possible power dissipation during the time period between to and t₁, when the field current 41 is applied and the junction 2 is not yet heated.

In yet another embodiment of the invention represented in Fig. 3D, the heating current 31 is first applied in the current line 8 at to and switched off by turning the transistor 3 OFF at a time t₁, when the junction 2 is sufficiently heated. At the same time t₁, the field current 41 is simultaneously applied in line 8, during the cooling of the junction 2 and then turned off at a time t₂. The pulse sequence of Fig. 3D can have possible critical timing constraints between the switching of the magnetization of the storage layer 23 and timing of heating pulse 31. Indeed, since the field current 41 is applied only when the heating current 31 is turned off, the period of time when the junction 2 is heated enough for easy switching of the magnetization of the storage layer 23 is short compared to the cases of pulse sequence of Fig. 3A to 3C.

In the cell configuration of Fig. 2, the heating current 31 flowing through the junction 2 must be effectively controlled to prevent over or under heating of the junction 2. The drain bias of the transistor 3 varies along the current line 8, however, due to ohmic drop of the metal current line 8 having a finite resistance, when the heating and/or field current 31, 41 are passed within the line 8. Here, the heating current 31 can be controlled by management of the bias on the word line 6. For example, the heating current 31 can be controlled by operating the select transistor 3 in the conducting mode (ON) where the heating current 31 is essentially controlled by the voltage of the word line 6 and only secondarily by the drain bias of the transistor 3. Controlling heating current 31 in this way also safeguards against exposing the junction to potentially harmful voltages. Moreover, the resistance of the current line 8 is used to limit or regulate the field current 41.

In order to keep transistor 3 current relatively constant regardless of its physical array position along current line 8, it may be necessary to periodically segment the current line 8, for example in an array as defined above. This array segmentation can however result in reduced array efficiency. The need for segmentation may be mitigated by decreasing the field current 41, for example by cladding current line 8.

The cell 1 of the invention allow for effective cell size which are significantly reduced with respect with conventional cells due to the removal of the field line 5 and since the cell 1 can be stacked, completely or partially, on the transistor 3 as in the cell configuration of Fig. 1 b. For example, in the case of a130 nm technology, simple design layout shows a two times decrease of effective cell size for a given field and heating currents 41, 31. Consequently, the cell 1 of the invention can be easily downscaled and magnetic memory devices having an increased cell density can be obtained.

In contrast with the cell configuration of prior art, the cell of the configuration of Fig. 2 requires only two CMOS metal levels, M1 1 and M2. The lower number of metal levels results in a lower manufacturing complexity and cost due to the reduced number of masks steps to manufacture.

Moreover, the current line 8 being electrically connected to the junction 2, the field current 41 passing in the current line 8 generate a magnetic field 42 that is maximized compared to the one of the cell configurations of Fig. 1 a and 1 b, due to proximity of the current line 8 to the storage layer 23. The cell configurations of Fig. 2 thus allows for using a lower field current 41, decreased the cell power consumption, and allowing for larger ratio of magnetic field 42 to field current 41.

The cell 1 disclosed above is susceptible to various modifications and alternative forms, and specific examples thereof have been shown by way of example in the drawings and are herein described in detail. It should be understood, however, that the disclosure is not to be limited to the particular forms or methods disclosed, but to the contrary, the disclosure is to cover all modifications, equivalents, and alternatives.

### Reference Numbers and Symbols

- 1: SL-TAS cell
- 2: magnetic tunnel junction
- 21: storage layer (first magnetic layer)
- 22: Insulating layer
- 23: reference layer (second magnetic layer)
- 3: select transistor
- 31: heating current (first portion of current)
- 32: sense current
- 4: bit line
- 41: field current (second portion of current)
- 42: magnetic field
- 5: field line
- 6: word line
- 7: strap
- 8: current line
- d: spacing between the field line and the cell strap
- h: magnitude of field current
- I_{bl}: total current passing in the current line
- I_{f}: magnitude of field current
- Iₕ: magnitude of heating current
- R: junction resistance
- WRT: write time

## Claims

1. A method of writing data in a magnetic memory cell (1) with a thermally assisted switching writing procedure, comprising:
a magnetic tunnel junction (2) containing at least a first magnetic layer (23), a second magnetic layer (21), and an insulating layer (22) being disposed between the first and a second magnetic layers (23, 21);
a select transistor (3), controlled by a word line (6); and
a current line (8) electrically connected to the junction (2) and having a first function for passing a heating current (31) for heating the junction (2), and a second function for passing a field current (41) for generating a magnetic field (42) adapted to switch the magnetization of the first magnetic layer (23) when the junction (2) has reached a suitable temperature; the method comprising:
a) turning on the heating current (31) through the junction (2) via the current line (8) in order to heat the junction (2);
b) turning on the field current (41) through the current line (8) in order to switch the magnetization of the storage layer (23);
c) after the junction (2) has reached the suitable high temperature threshold, turning off the heating current (31) in order to cool the junction (2);
d) after the junction (2) has cooled down to a low temperature threshold, turning off the field current (41);
**characterized in that**
turning on the heating current (31) is performed prior to turning on the field current (41), and turning off the heating current (31) is performed after turning on the field current (41) and prior to turning off the field current (41).

2. The method according to claim 1, wherein
the first portion of current (31) is essentially controlled by the voltage of the word line (6) when the select transistor (3) is operated in a conducting mode (ON).

3. The method according to the claims 1 or 2, wherein
the current line (8) has a finite resistance, said resistance being used to limit or regulate the second portion of current (41).

## Patentansprüche

1. Ein Schreibverfahren von Daten in einer magnetischen Speicherzelle (1) mit einem thermisch assistierten Schreibschaltverfahren, umfassend:
einen magnetischen Tunnelübergang (2) enthaltend mindestens eine erste magnetische Schicht (23), eine zweite magnetische Schicht (23), und eine Isolationsschicht (21), die sich zwischen der ersten und der zweiten magnetischen Schicht (23, 21) befindet;
einen Auswahltransistor (3), der durch eine Wortleitung (6) kontrolliert wird; und
eine Stromleitung (8), die elektrisch mit dem Übergang (2) verbunden ist, mit einer ersten Funktion, um einen Heizstrom (31) durchzuleiten, um den Übergang (2) zu heizen, und eine zweite Funktion, um einen Feldstrom (41) durchzuleiten, um ein magnetisches Feld (42) zu generieren, das angepasst ist, um die Magnetisierung der ersten magnetischen Schicht (23) zu schalten, wenn der Übergang (2) eine geeignete Temperatur erreicht hat, das Verfahren umfassend:
a) Anstellen des Heizstroms (31) durch den Übergang (2) mittels der Stromleitung (8), um den Übergang (2) zu heizen;
b) Anstellen des Feldstroms (41) durch die Stromleitung (8), um die Magnetisierung der Speicherschicht (23) zu schalten;
c) nachdem der Übergang (2) die geeignete hoch Temperaturschwelle erreicht hat, Abschalten des Heizstroms (31), um den Übergang (2) zu kühlen;
d) nachdem der Übergang (2) zu einer Temperatur unterhalb einer Temperaturschwelle abgekühlt ist, Abschalten des Feldstroms (41);
**gekennzeichnet dadurch, dass**
das Anstellen des Heizstroms (31) vor dem Anstellen des Feldstroms (41) durchgeführt wird, und dass das Abstellen des Heizstroms (31) durchgeführt wird, nachdem der Feldstrom (41) angestellt worden ist, und vor dem Abstellen des Feldstroms (41).

2. Das Verfahren gemäss Anspruch 1, wobei der erste Teil des Stroms (31) im Wesentlichen durch die Spannung der Wortleitung (6) kontrolliert wird, wenn der Auswahltransistor (3) in einem Leitungsmodus (ON) betrieben wird.

3. Das Verfahren gemäss den Ansprüchen 1 oder 2, wobei die Stromleitung (8) einen begrenzten Widerstand hat, besagter Widerstand wird verwendet, um den zweiten Teil des Stroms (41) zu begrenzen oder zu regulieren.

## Revendications

1. Une méthode d'écriture des données dans une cellule de mémoire magnétique (1) avec une opération d'écriture à renversement assisté thermiquement, comprenant:
une jonction tunnel magnétique (2) comprenant au moins une première couche magnétique (23), une seconde couche magnétique (23), et une couche isolante (21) étant disposée entre la première et la seconde couche magnétique (23, 21);
un transistor de sélection (3) contrôlé par une ligne de mots (6); et
une ligne de courant (8) reliée électriquement à la jonction (2) présentant une première fonction pour passer un courant de chauffage (31) pour chauffer la jonction (2), et une seconde fonction pour passer un courant de champ (41) pour générer un champ magnétique (42) adapté pour renverser l'aimantation de la première couche magnétique (23) lorsque la jonction (2) a atteint une température appropriée ; la méthode comprenant:
a) enclencher le courant de chauffage (31) à travers la jonction (2) au moyen de la ligne de courant (8) pour chauffer la jonction (2);
b) enclencher le courant de champ (41) à travers la ligne de courant (8) pour renverser l'aimantation de la couche de stockage (23);
c) après que la jonction (2) ait atteint la température appropriée, couper le courant de chauffage (31) pour refroidir la jonction (2);
d) après que la jonction (2) ait refroidit à une température de seuil basse, couper le courant de champ (41);
**caractérisée en ce que**
l'enclenchement du courant de chauffage (31) est effectué avant l'enclenchement du courant de champ (41), et que l'arrêt du courant de chauffage est effectué après que le courant de champ (41) ait été enclenché et avant l'arrêt du courant de champ (41).

2. Méthode selon la revendication 1, selon laquelle la première portion de courant (31) est essentiellement contrôlée par le voltage de la ligne de courant (6), lorsque le transistor de sélection (3) est utilisé dans un mode marche (ON).

3. Méthode selon les revendications 1 ou 2, selon laquelle la ligne de courant (8) possède une résistance limitée, ladite résistance étant utilisée pour limiter ou réguler la seconde portion de courant (41).
